# EUROPEAN PATENT APPLICATION

(11) **EP 4 808 314 A1**
(43) Date of publication of application: **16.09.2026**
(21) Application number: 26158448.6
(22) Date of filing: 13.02.2026
(51) Int. Cl.: H10F 39/18, H10F 39/12, H10F 39/00

(54) **GUARD REGION FOR RADIATION SENSOR**

(30) Priority: 10.03.2025 US 202519075319
(71) Applicant: GE Precision Healthcare LLC, Waukesha, WI 53188 (US)
(72) Inventor: JACOB, Biju, Niskayuna 12309-1027 (US); HENNESSY, William Andrew, Niskayuna 12309-1027 (US); CAMPANINI, Donato, Waukesha 53188 (US); KONKLE, Nicholas Ryan, Waukesha 53188 (US)
(74) Representative: AWA Sweden AB

(57) **Abstract**

A radiation imaging apparatus includes a substrate (92) and a radiation-sensitive imaging region (96) in the substrate (92) including a plurality of pixels (93) disposed on a surface of the substrate (92), wherein each pixel (93) is configured to act as a detector element. The radiation imaging apparatus also includes a guard region (94) disposed on the surface and including a plurality of guard rings (101) disposed about a periphery of the radiation-sensitive imaging region (96) at or immediately adjacent a cut edge (95) of the substrate (92), wherein the guard region (94) forms an inactive region (98) about the periphery of the radiation-sensitive imaging region (96), and the guard region (94) includes at least one trench (110) formed in the guard region (94) disposed about the periphery of the radiation-sensitive imaging region (96), and wherein the at least one trench (110) is configured to improve detection efficiency of pixels (93) of the plurality of pixels (93) located closest to the cut edge (95) while reducing a width (108) of the guard region (94).

## Description

### BACKGROUND

The subject matter disclosed herein relates to imaging systems and, more particularly, to a guard region for a radiation sensor.

Non-invasive imaging technologies allow images of the internal structures or features of a subject (patient, manufactured good, baggage, package, or passenger) to be obtained without physical contact.

For example, in X-ray-based imaging technologies, X-ray radiation penetrates a subject of interest, such as a human patient, and a portion of the radiation impacts a detector where the intensity data is collected. In digital X-ray systems, a detector produces signals representative of the amount or intensity of radiation impacting discrete pixel regions of a detector surface. The signals may then be processed to generate an image that may be displayed for review.

In one such X-ray based technique, known as computed tomography (CT), a scanner may project fan-shaped or cone-shaped X-ray beams from an X-ray source at numerous view angle positions about an object being imaged, such as a patient. The X-ray beams are attenuated as they traverse the object and are detected by a set of detector elements which produce signals representing the intensity or number of incident X-rays reaching the detector. The signals are processed to produce data representing the line integrals of the linear attenuation coefficients of the object along the X-ray paths. These signals are typically called "projection data" or just "projections". By using reconstruction techniques, such as filtered backprojection, images may be generated that represent a cross sectional slice or three-dimensional (3D) volume of a region of interest of the patient or imaged object. In a medical context, pathologies or other structures of interest may then be located or identified from the reconstructed images or rendered volume.

Some CT detectors include photon counting detectors. A photon counting detector converts each detected X-ray photon in the energy unit (keV) into a voltage pulse in the pulse height unit (mV). An X-ray photon is absorbed in a semiconductor material (e.g., cadmium zinc telluride (CZT), silicon, etc.) resulting in generation of photocharge proportional to the X-ray photon energy. A photodiode or diode, separates the electron-hole pairs and generates a current pulse at its output. The current is fed into application-specific integrated circuit (ASIC), which tracks individual current pulses, determines the energy of the X-ray photons that generated these pulses and assigns them to the appropriate energy bins.

In the state-of-the-art photon counting detectors, the semiconductor sensor (e.g., radiation sensor) consists of an array of photodiode pixels (e.g., diodes). Guard rings protect radiation sensors from premature breakdown and improve their long term stability. However, guard rings take up a significant portion (e.g., several 100s of micrometers (µm)) of the silicon and is especially problematic for radiation sensors that are tiled to build area detectors. The region covered by guard rings are essentially inactive or dead. There is a need to improve guard ring design to reduce the dead area.

### SUMMARY

Certain embodiments commensurate in scope with the originally claimed subject matter are summarized below. These embodiments are not intended to limit the scope of the claimed subject matter, but rather these embodiments are intended only to provide a brief summary of possible forms of the subject matter. Indeed, the subject matter may encompass a variety of forms that may be similar to or different from the embodiments set forth below.

In one embodiment, a radiation imaging apparatus is provided. The radiation imaging apparatus includes a substrate. The radiation imaging apparatus includes a radiation-sensitive imaging region in the substrate including a plurality of pixels disposed on a surface of the substrate, wherein each pixel of the plurality of pixels is configured to act as a detector element. The radiation imaging apparatus also includes a guard region disposed on the surface and including a plurality of guard rings disposed about a periphery of the radiation-sensitive imaging region at or immediately adjacent a cut edge of the substrate, wherein the guard region is configured to prevent premature electrical breakdown of the radiation imaging apparatus, wherein the guard region forms an inactive region about the periphery of the radiation-sensitive imaging region, and the guard region includes at least one trench formed in the surface in the guard region disposed about the periphery of the radiation-sensitive imaging region, and wherein the at least one trench is configured to improve detection efficiency of pixels of the plurality of pixels located closest to the cut edge while reducing a width of the guard region.

In another embodiment, a method of manufacturing a radiation imaging apparatus is provided. The method includes providing a substrate with a radiation-sensitive imaging region therein, wherein the radiation-sensitive imaging region includes a plurality of pixels disposed on a surface of the substrate, wherein each pixel of the plurality of pixels is configured to act as a detector element. The method also includes forming a guard region including a plurality of guard rings on the surface about a periphery of the radiation-sensitive imaging region at or immediately adjacent a cut edge of the substrate and to prevent premature electrical breakdown of the radiation imaging apparatus when the radiation imaging apparatus is in use, wherein the guard region forms an inactive region about the periphery of the radiation-sensitive imaging region. The method further includes forming at least one trench in the surface in the guard region disposed about the periphery of the radiation-sensitive imaging region to improve detection efficiency of pixels of the plurality of pixels located closest to the cut edge when the radiation imaging apparatus is in use while reducing a width of the guard region.

In a further embodiment, a photon-counting X-ray detector is provided. The photon counting detector includes a plurality of detector sub-modules. Each detector sub-module includes a semiconductor layer. Each detector sub-module also includes a radiation-sensitive imaging region in the semiconductor layer, wherein the radiation-sensitive imaging region includes a plurality of pixels disposed on a surface of the semiconductor layer, wherein each pixel of the plurality of pixels is configured to act as a detector element. Each detector sub-module further includes a guard region disposed on the surface and including a plurality of guard rings disposed about a periphery of the radiation-sensitive imaging region at or immediately adjacent a cut edge of the semiconductor layer, wherein the guard region is configured to prevent premature electrical breakdown of the detector sub-module, wherein the guard region forms an inactive region about the periphery of the radiation-sensitive imaging region, and the guard region includes at least one trench formed in the surface in the guard region disposed about the periphery of the radiation-sensitive imaging region, and wherein the at least one trench is configured to improve detection efficiency of pixels of the plurality of pixels located closest to the cut edge while reducing a width of the guard region.

### BRIEF DESCRIPTION OF THE DRAWINGS

These and other features, aspects, and advantages of the disclosed subject matter will become better understood when the following detailed description is read with reference to the accompanying drawings in which like characters represent like parts throughout the drawings, wherein:
FIGS. 1A and 1B are a pictorial view and a block diagram representation, respectively, of a CT system, in accordance with aspects of the present disclosure;
FIG. 2 is a schematic diagram illustrating an example of modular X-ray detector sub-modules arranged side-by-side and stacked one after the other, in accordance with aspects of the present disclosure;
FIG. 3 is a cross-sectional view through a portion of an X-ray detector sub-module, in accordance with aspects of the present disclosure;
FIG. 4 is a schematic diagram of a sensor having a guard region with one or more trenches, in accordance with aspects of the present disclosure;
FIG. 5 is a top view of a portion of the sensor including the guard region (without trenches);
FIG. 6 is a schematic diagram comparing a guard region without trenches to a guard region with trenches, in accordance with aspects of the present disclosure;
FIG. 7 depicts simulated guard region designs for use in simulated breakdown voltage comparison, in accordance with aspects of the present disclosure;
FIG. 8 depicts a graph of the comparison in simulated breakdown voltage for the simulated guard region designs in FIG. 7, in accordance with aspects of the present disclosure;
FIG. 9 depicts an electric field in the simulated guard region designs in FIG. 7, in accordance with aspects of the present disclosure;
FIG. 10 depicts a graph of a comparison of electric field between the simulated guard region designs in FIG. 7, in accordance with aspects of the present disclosure;
FIG. 11 depicts trenches of different depths formed in a semiconductor layer, in accordance with aspects of the present disclosure;
FIG. 12 depicts a schematic diagram of a side view of a portion of a guard region of a sensor having a trench with an additional layer disposed on the trench's surfaces, in accordance with aspects of the present disclosure;
FIG. 13 depicts a schematic diagram of a side view of a portion of a guard region of a sensor having a trench having a concave shape, in accordance with aspects of the present disclosure;
FIG. 14 depicts a schematic diagram of a side view of a portion of a guard region of a sensor having a trench having a v-shape, in accordance with aspects of the present disclosure;
FIG. 15 depicts a schematic diagram of a side view of a portion of a guard region of a sensor having a trench having a w-shape, in accordance with aspects of the present disclosure;
FIG. 16 is a flow chart of a method of manufacturing a radiation imaging apparatus, in accordance with aspects of the present disclosure.

### DETAILED DESCRIPTION

One or more specific embodiments will be described below. In an effort to provide a concise description of these embodiments, not all features of an actual implementation are described in the specification. It should be appreciated that in the development of any such actual implementation, as in any engineering or design project, numerous implementation-specific decisions must be made to achieve the developers' specific goals, such as compliance with system-related and business-related constraints, which may vary from one implementation to another. Moreover, it should be appreciated that such a development effort might be complex and time consuming, but would nevertheless be a routine undertaking of design, fabrication, and manufacture for those of ordinary skill having the benefit of this disclosure.

When introducing elements of various embodiments of the present subject matter, the articles "a," "an," "the," and "said" are intended to mean that there are one or more of the elements. The terms "comprising," "including," and "having" are intended to be inclusive and mean that there may be additional elements other than the listed elements. Furthermore, any numerical examples in the following discussion are intended to be non-limiting, and thus additional numerical values, ranges, and percentages are within the scope of the disclosed embodiments.

While aspects of the following discussion are provided in the context of medical imaging, it should be appreciated that the disclosed techniques are not limited to such medical contexts. Indeed, the provision of examples and explanations in such a medical context is only to facilitate explanation by providing instances of real-world implementations and applications. However, the disclosed techniques may also be utilized in other contexts, such as image reconstruction for non-destructive inspection of manufactured parts or goods (i.e., quality control or quality review applications), and/or the non-invasive inspection of packages, boxes, luggage, and so forth (i.e., security or screening applications). In general, the disclosed techniques may be useful in any imaging or screening context or image processing or photography field where a set or type of acquired data undergoes a reconstruction process to generate an image or volume.

Energy-resolved, photon counting detectors can provide spectral information that is not available with conventional energy-integrating detectors. One type of energy-discriminating, photon counting detection technology employs silicon strips as a direct-conversion sensor material. Use of silicon as the direct-conversion material may provide a higher count rate capability than may be obtained with other direct-conversion materials, such as CZT or CdTe. In certain embodiments, the detector may be arranged edge-on to increase absorption efficiency by enabling an absorption depth to be chosen to any length and the detector can still be fully depleted without going to very high voltages. The detector sub-modules or sensors may include detector elements forming an active region (e.g., radiation sensitive imaging region). A guard region (e.g., guard region structure) forms an inactive region disposed about the periphery of the active region adjacent an edge (e.g., cut edge) of a substrate of the detector sub-module or sensor. While the guard region prevents premature electrical breakdown of the detector sub-module or sensor, it takes up a significant portion of the substrate (e.g., hundreds of micrometers on each side of the sensor that is equivalent to a width of a pixel on each side). The detector elements disposed along an edge of the detector sub-module or sensor (closest to the guard region) experience a significant loss of detection efficiency due to the large guard region.

The present approaches mitigate this problem by providing a narrower guard region (e.g., narrower guard ring structure). In particular, one or more trenches are formed in a substrate (e.g., semiconductor layer) of a radiation sensor in guard region (e.g., between guard rings) to increase a surface area to enable the reduction in the width of the guard region (and/or reduction in number of guard rings). The one or more trenches enables the guard region to achieve a similar or better breakdown voltage (with the significantly reduced guard region width) while enabling recovery of the detection efficiency loss in the edge channels of the radiation sensor. As noted, the narrower guard region improves detection efficiency of pixels in the edge of the radiation sensor. This directly improves the image quality while reducing the complexity of system calibration and correction algorithms. The present approaches may enable a simpler detector design (e.g., straight sensors as opposed to overlapping sensors) to reduce cost. The present approaches may reduce the inactive (dead) area on the periphery of the sensor by 30 percent or more.

In certain embodiments, a radiation imaging apparatus includes a substrate. The radiation imaging apparatus includes a radiation-sensitive imaging region in the substrate including a plurality of pixels (e.g., pixel electrodes) disposed on a surface of the substrate, wherein each pixel of the plurality of pixels is configured to act as a detector element. The radiation imaging apparatus also includes a guard region disposed on the surface and including a plurality of guard rings disposed about a periphery of the radiation-sensitive imaging region at or immediately adjacent a cut edge of the substrate, wherein the guard region is configured to prevent premature electrical breakdown of the radiation imaging apparatus, wherein the guard region forms an inactive region about the periphery of the radiation-sensitive imaging region, and the guard region includes at least one trench formed in the surface in the guard region disposed about the periphery of the radiation-sensitive imaging region, and wherein the at least one trench is configured to improve detection efficiency of pixels of the plurality of pixels located closest to the cut edge while reducing a width of the guard region.

In certain embodiments, the at least one trench is disposed adjacent to a guard ring of the plurality of guard rings. In certain embodiments, the at least one trench is disposed between a pair of guard rings of the plurality of guard rings. In certain embodiments, the radiation imaging apparatus further includes a plurality of trenches formed in the surface in the guard region about the periphery of the radiation-sensitive imaging region, wherein each trench of the plurality of trenches is disposed between a respective pair of guard rings of the plurality of guard rings. In certain embodiments, the plurality of trenches vary in width. In certain embodiments, the plurality of trenches vary in depth. In certain embodiments, the at least one trench is formed in an undoped region. In certain embodiments, the radiation imaging apparatus further includes a passivation layer disposed over each surface of the at least one trench. In certain embodiments, the radiation imaging apparatus further includes a tin oxide layer disposed over each surface the at least one trench. In certain embodiments, the radiation imaging apparatus includes a photon counting X-ray detector. In certain embodiments, the photon counting X-ray detector is configured to be utilized with a computed tomography imaging system or a projectional radiographic imaging system.

In certain embodiments, a method of manufacturing a radiation imaging apparatus includes providing a substrate with a radiation-sensitive imaging region therein, wherein the radiation-sensitive imaging region includes a plurality of pixels disposed on a surface of the substrate, wherein each pixel of the plurality of pixels is configured to act as a detector element. The method also includes forming a guard region including a plurality of guard rings on the surface about a periphery of the radiation-sensitive imaging region at or immediately adjacent a cut edge of the substrate and to prevent premature electrical breakdown of the radiation imaging apparatus when the radiation imaging apparatus is in use, wherein the guard region forms an inactive region about the periphery of the radiation-sensitive imaging region. The method further includes forming at least one trench in the surface in the guard region disposed about the periphery of the radiation-sensitive imaging region to improve detection efficiency of pixels of the plurality of pixels located closest to the cut edge when the radiation imaging apparatus is in use while reducing a width of the guard region.

In certain embodiments, the method further includes further includes utilizing deep reactive ion etching to form the at least trench in the surface. In certain embodiments, the method further includes forming a plurality of trenches in the surface in the guard region about the periphery of the radiation-sensitive imaging region, wherein each trench of the plurality of trenches is disposed between a respective pair of guard rings of the plurality of guard rings.

In certain embodiments, a photon-counting X-ray detector includes a plurality of detector sub-modules. Each detector sub-module includes a semiconductor layer. Each detector sub-module also includes a radiation-sensitive imaging region in the semiconductor layer, wherein the radiation-sensitive imaging region includes a plurality of pixels disposed on a surface of the semiconductor layer, wherein each pixel of the plurality of pixels is configured to act as a detector element. Each detector sub-module further includes a guard region disposed on the surface and including a plurality of guard rings disposed about a periphery of the radiation-sensitive imaging region at or immediately adjacent a cut edge of the semiconductor layer, wherein the guard region is configured to prevent premature electrical breakdown of the detector sub-module, wherein the guard region forms an inactive region about the periphery of the radiation-sensitive imaging region, and the guard region includes at least one trench formed in the surface in the guard region disposed about the periphery of the radiation-sensitive imaging region, and wherein the at least one trench is configured to improve detection efficiency of pixels of the plurality of pixels located closest to the cut edge while reducing a width of the guard region.

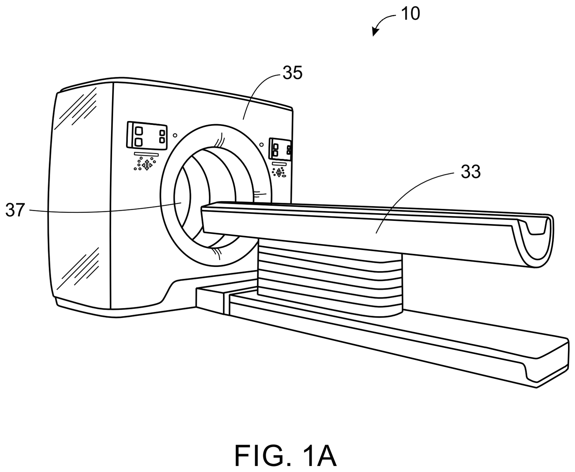

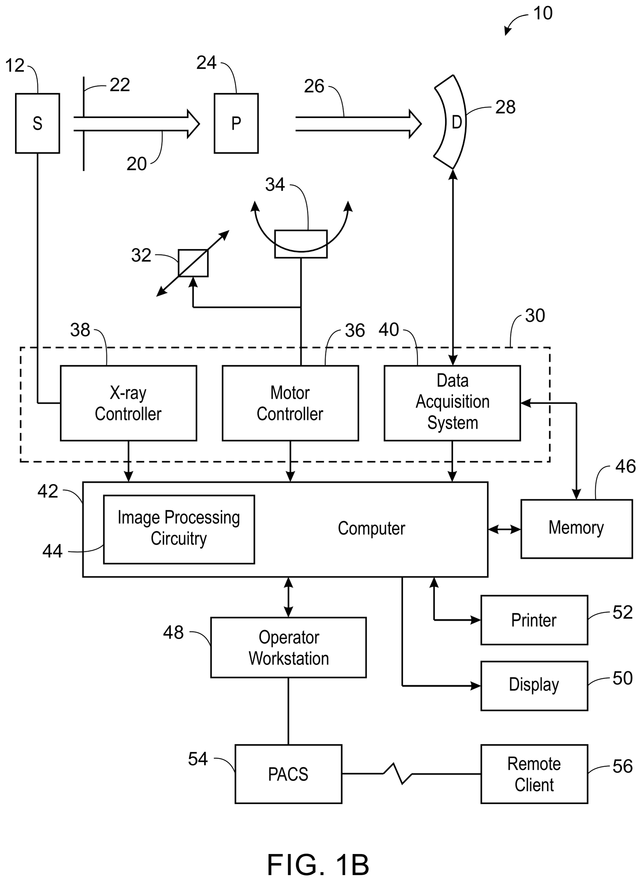

With the preceding discussion in mind, FIGS. 1A and 1B illustrate an embodiment of an imaging system 10 for acquiring and processing image data utilizing the techniques discussed herein. Although the following embodiments are discussed in terms of the computed tomography (CT) imaging system, the embodiments may also be utilized with other imaging systems (e.g., X-ray, PET, CT/PET, SPECT, nuclear CT, etc.). In particular, the disclosed detector may be utilized with a projectional (i.e., conventional) radiographic imaging system. In the illustrated embodiment, system 10 is a computed tomography (CT) system designed to acquire X-ray projection data, to reconstruct the projection data into a tomographic image, and to process the image data for display and analysis. The CT imaging system 10 includes one or more X-ray sources 12, such as one or more X-ray tubes or solid-state emission structures which allow X-ray generation at one or more locations and/or one or more energy spectra during an imaging session.

In certain implementations, the source 12 may be positioned proximate to a collimator 22 used to define the size and shape of the one or more X-ray beams 20 that pass into a region in which a subject 24 (e.g., a patient) or object of interest is positioned. The subject 24 attenuates at least a portion of the X-rays. Resulting attenuated X-rays 26 impact a detector array 28 formed by a plurality of detector elements (e.g., pixels). As discussed herein, the detector 28 may be a photon counting detector, including an energy-discriminating photon counting detector, whose outputs convey information about the number and energy of photons that impact the detector at measured positions and over a time interval corresponding to a scan or imaging session. In certain such embodiments, the energy-discriminating, photon counting detector may be a direct-conversion type detector (i.e., not employing a scintillator intermediary), such as a detector based on silicon strips. In certain embodiments, the detector array 28 may be formed by a plurality of detector sub-modules or sensors (each having a plurality of detector elements such as photodiode or diodes). In certain embodiments, the detector array 28 and the detector sub-modules may be an edge-on detector and edge-on detector sub-modules configured for edge illumination from the X-rays (i.e., the X-rays enter through the edge of the detector sub-modules).

Each detector element produces an electrical signal that represents the intensity of the incident X-ray photons (e.g., the energy and number of incident photons) at the position of the detector element when the beam strikes the detector 28. Electrical signals are acquired and processed to generate one or more scan datasets.

A system controller 30 commands operation of the imaging system 10 to execute examination and/or calibration protocols and to process the acquired data. With respect to the X-ray source 12, the system controller 30 furnishes power, focal spot location, control signals and so forth, for the X-ray examination sequences. The detector 28 is coupled to the system controller 30, which commands acquisition of the signals generated by the detector 28. In addition, the system controller 30, via a motor controller 36, may control operation of a linear positioning subsystem 32 (e.g., a table 33 in FIG. 1A) and/or a rotational subsystem 34 (e.g., a gantry 35 in FIG. 1A, a C-arm, etc.) used to move components of the imaging system 10 and/or the subject 24 (e.g., moving the subject 24 into and out of a bore or opening 37 of the gantry 35 in FIG. 1A). The system controller 30 may include signal processing circuitry and associated memory circuitry. In such embodiments, the memory circuitry may store programs, routines, and/or encoded algorithms executed by the system controller 30 to operate the imaging system 10, including the X-ray source 12, and to process the data acquired by the detector 28 in accordance with the steps and processes discussed herein. In one embodiment, the system controller 30 may be implemented as all or part of a processor-based system such as a general purpose or application-specific computer system.

The source 12 may be controlled by an X-ray controller 38 contained within the system controller 30. The X-ray controller 38 may be configured to provide power and timing signals to the source 12. In addition, in some embodiments the X-ray controller 38 may be configured to selectively activate the source 12 such that tubes or emitters at different locations within the system 10 may be operated in synchrony with one another or independent of one another.

The system controller 30 may include a data acquisition system (DAS) 40. The DAS 40 receives data collected by readout electronics (e.g., ASICs) of the detector 28, such as sampled analog signals from the detector 28. The DAS 40 may then convert the data to digital signals for subsequent processing by a processor-based system, such as a computer 42. In other embodiments, the detector 28 may convert the sampled analog signals to digital signals prior to transmission to the data acquisition system 40. The computer may include processing circuitry 44 (e.g., image processing circuitry). The computer 42 may include or communicate with one or more non-transitory memory devices 46 that can store data processed by the computer 42, data to be processed by the computer 42, or instructions to be executed by a processor (e.g., processing circuitry 44) of the computer 42. For example, the processing circuitry 44 of the computer 42 may execute one or more sets of instructions stored on the memory 46, which may be a memory of the computer 42, a memory of the processor, firmware, or a similar instantiation.

The computer 42 may also be adapted to control features enabled by the system controller 30 (i.e., scanning operations and data acquisition), such as in response to commands and scanning parameters provided by an operator via an operator workstation 48. The system 10 may also include a display 50 coupled to the operator workstation 48 that allows the operator to view relevant system data, imaging parameters, raw imaging data, reconstructed data, and so forth. Additionally, the system 10 may include a printer 52 coupled to the operator workstation 48 and configured to print any desired measurement results. The display 50 and the printer 52 may also be connected to the computer 42 directly or via the operator workstation 48. Further, the operator workstation 48 may include or be coupled to a picture archiving and communications system (PACS) 54. PACS 54 may be coupled to a remote system 56, radiology department information system (RIS), hospital information system (HIS) or to an internal or external network, so that others at different locations can gain access to the image data.

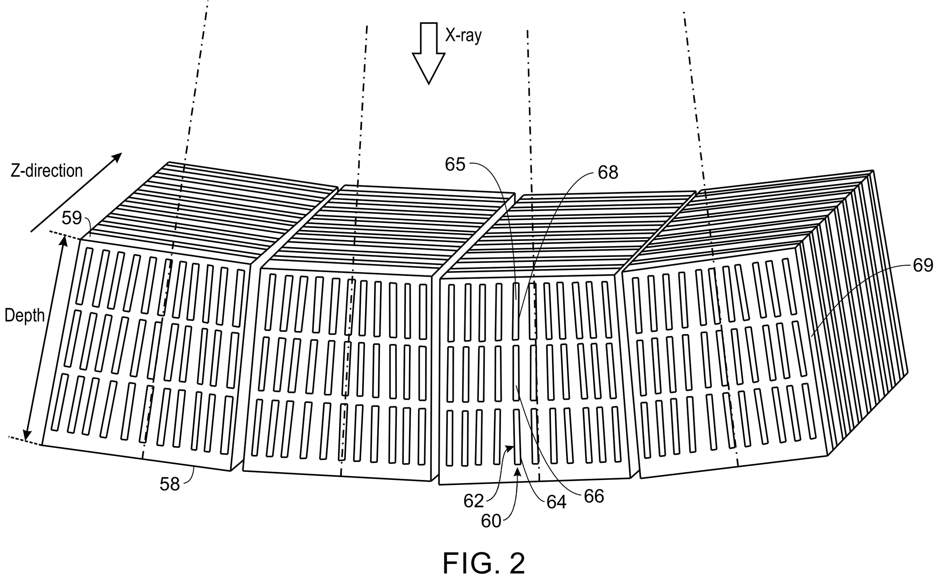

FIG. 2 is a schematic diagram illustrating an example of a modular X-ray detector sub-module 58 (e.g., detector sensors) arranged side-by-side and stacked one after the other. The detector sub-modules 58 may be edge-on detector sub-modules. As depicted, X-rays enter through an edge 59 of the detector sub-module 58. A guard region (e.g., guard ring structure) may extend along the edges 59 of the detector sub-module 58 to protect the detector sub-module 58 from electrical breakdown and isolate the detector area from excessive leakage current. In certain embodiments, the detector sub-modules 58 may be planar modules. The X-ray detector sub-modules 58 may be stacked one after the other to form larger detector modules that may be assembled together side-by side to build up an overall X-ray detector. The detector sub-modules 58 may generally be arranged side-by-side, e.g., in a slightly curved overall configuration, in a direction substantially perpendicular to the z-direction. In certain embodiments, the detector sub-modules 58 may be stacked one after the other in the z-direction.

As depicted, each detector sub-module 58 includes a plurality of detector elements 60 (e.g., pixels or pixel electrodes such photodiodes or diodes). The detector elements 60 may be elongated electrodes (e.g., metal photodiode electrodes) with the length extension directed towards a focal point of an X-ray system. Depending on the detector topology, the detector element 60 may correspond to a pixel. In certain embodiments, the detector sub-module 58 may be a depth-segmented detector sub-module having a number of detector strips 62 with each strip 62 having a number of depth segments 65. As depicted, each strip 62 has a first segment 64, a second segment 66, and a third segment 68 associated with a different depth (relative to the focal point) along a detection line. As depicted, at least portions of each segment 64, 66, 68 are co-linearly arranged. The number of segments 65 may vary (e.g., 1 to 3 or more). For such a depth-segmented detector sub-module 58, each depth segment 65 may be regarded as an individual detector element (if each depth segment is associated with its own individual charge collecting electrode). In certain embodiments, circuitry may treat the depth segments 65 of a single strip 62 logically as a single detector element.

The shape of the detector sub-module 58 may vary. In certain embodiments, the detector sub-module 58 may have a parallelogram shape, a trapezoidal shape, a triangular shape, or another shape. In certain embodiments, one or more edges 59 of the detector sub-module 58 may be slanted. The shapes of the detector elements 60 may vary. In certain embodiments, the detector elements 60 arranged along a slanted side edge 69 of the detector sub-module 58 may include tapered edge segments (e.g., trapezoidal or triangular segments and/or truncated trapezoidal or triangular segments with rounded corners). In certain embodiments, a segment 65 of a strip 62 that is closest to a slanted side edge of a detector sub-module 58 may be orientated so that it extends into an area of an adjacent strip 62. In certain embodiments, the segments 65 may also be slanted.

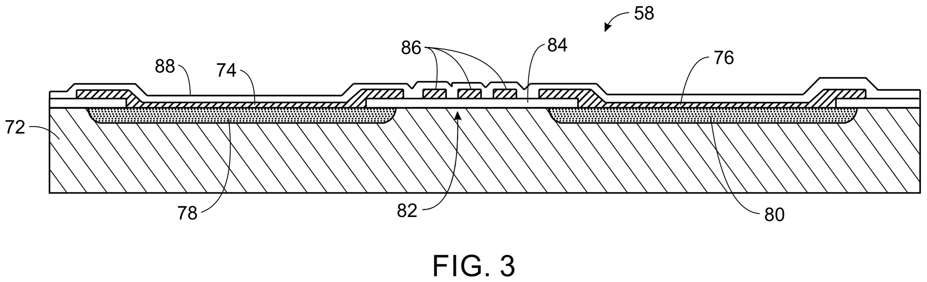

FIG. 3 is a cross-sectional view through a portion of the X-ray detector sub-module 58. The X-ray detector sub-module 58 includes a semiconductor layer 72. The semiconductor layer 72 is made of silicon. In certain embodiments, the semiconductor layer 72 may be made of gallium arsenide, cadmium zinc telluride, or another semiconductor material. Detector elements or segments 74, 76 (e.g., metal photodiode electrodes) are disposed on the semiconductor layer 72. The electrodes may be made of aluminum. In particular, the electrodes 74, 76 are disposed on doped implants 78, 80 (e.g., p-type or n-type silicon implants depending on whether the silicon of the semiconductor layer is n-type or p-type) that are disposed on the semiconductor layer 72. The detector elements 74, 76 may be respective segments for different strips of segments disposed adjacent to each other. The detector elements 74, 76 and the doped implants 78, 80 are disposed on the semiconductor layer 72 spaced apart so that a gap 82 is formed between them. The X-ray detector sub-module 58 includes an electrical insulator layer 84 extending between the adjacent electrodes 74, 76. The electrical insulator layer 84 may be silicon dioxide, silicon nitride, polyimide, spin-on glass, or another insulating material. One or more wiring traces 86 (e.g., metal traces) are routed within the gap 82 between the electrodes 74, 76. As depicted, the wiring traces 86 are disposed on the electrical insulator layer 84. As depicted, the wiring traces 86 are disposed in an evenly spaced manner across the gap 82. In certain embodiments, the wiring traces 86 may be routed as close as possible to the edges of the electrodes 74, 76. The wiring traces 86 may be coupled to the electrodes 74, 76 or different electrodes. The wiring traces 86 are routed along the gap 82 (and possibly other gaps) to readout circuitry. As depicted, a passivation layer 88 is disposed over these components of the X-ray detector sub-module 58. The passivation layer 88 may be made of silicon oxide, silicon nitride or another insulator.

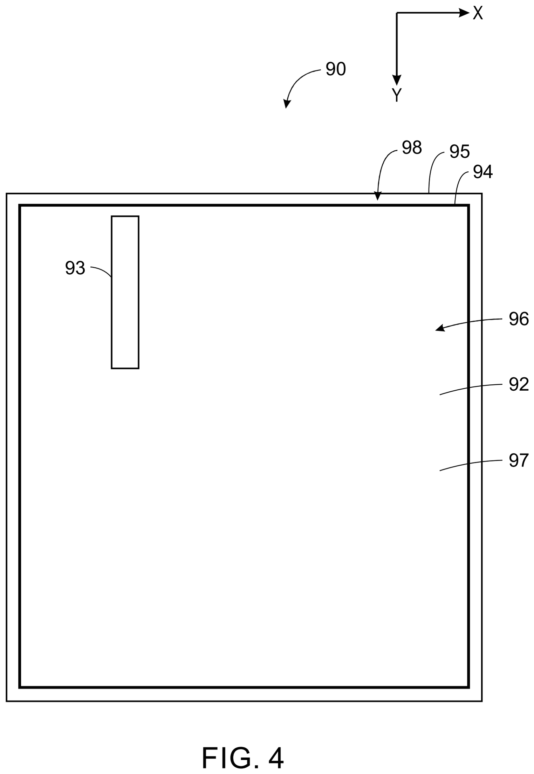

FIG. 4 is a schematic diagram of a sensor or radiation sensor 90 (e.g., modular X-ray detector sub-module 58 in FIGS. 2 and 3) having a guard region 94 with one or more trenches. As depicted, the sensor 90 includes a substrate 92 (e.g., semiconductor substrate or layer). A guard region 94 (e.g., guard ring structure) is disposed (on a surface 97 of the substrate 92) adjacent to and extends along edges 95 of the sensor 90 to protect the sensor 90 from electrical breakdown and isolate the detector area from excessive leakage current. The sensor 90 includes a radiation-sensitive imaging region 96 (e.g., active detector region) disposed within the guard region 94 (which the guard region 94 defines) and an inactive region 98 (i.e., radiation-insensitive or dead region) along the edges 95 outside the guard region 94. A plurality of pixel electrodes 93 (e.g., detector element 60 in FIG. 2) are disposed on a surface 97 of the substrate 92 within the radiation-sensitive imaging region 96 (only one pixel electrode 93 is shown for simplicity). The guard region 94 is also inactive. The guard region 94 is disposed about a periphery of the radiation-sensitive imaging region 96. The radiation-sensitive imaging region 96 is electrically reverse biased with respect to the substrate 92. As discussed in greater detail below, the guard region 94 includes one or more trenches formed in the substrate in the inactive region 98 disposed adjacent to and/or between guard rings of the guard region 94. The one or more trenches increase a surface area (in the guard region 94) to enable the reduction in the width of the guard region 94 (and/or reduction in number of guard rings). The one or more trenches enables the guard region 94 to achieve a similar or better breakdown voltage (with the significantly reduced guard region width) while enabling recovery of the detection efficiency loss in the edge channels of the radiation sensor 90.

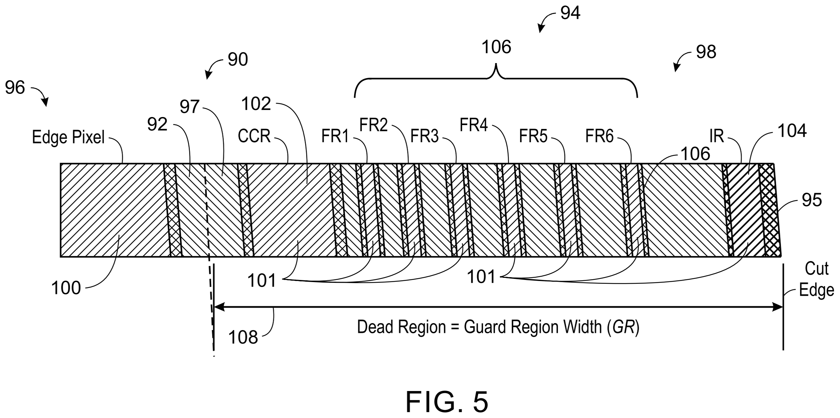

FIG. 5 is a top view of a portion of the sensor or radiation sensor 90 (e.g., modular X-ray detector sub-module 58 in FIGS. 2 and 3) without any trenches formed in the guard region 94. As depicted, an edge pixel electrode 100 (e.g., detector element 60 in FIG. 2) is disposed in the radiation-sensitive imaging region 96 adjacent the guard region 94 which is disposed in the inactive (dead) region 98. The guard region 94 is disposed adjacent to and extends along the edge 95 (e.g., cut edge) of the sensor 90. The guard region 94 includes a plurality of guard rings 101. As depicted, the guard rings 101 include a current capture guard electrode (CCR)) 102 to isolate the detector area from excessive leakage current. The guard rings 101 also include an implant ring (IR) 104 (e.g., n+ implant). The guard rings 101 also include a plurality of floating rings (FR) 106 (e.g., p+ implants). The implant ring 104 and the floating rings 106 are not electrically biased. The implant ring 104 and the floating rings 106 are not connected to any electrical contacts. The current capture guard electrode 102 is the most adjacent of the guard rings 101 to the radiation-sensitive imaging region 96. The implant ring 104 is the most adjacent of the guard rings 101 to the edge 95. The floating rings 106 are disposed between the current capture guard electrode 102 and the implant ring 104 in a spaced apart arrangement. The number of floating rings 106 may vary. As depicted, there are five floating rings 106. The guard region 94 and the inactive region 98 have a same width 108. As discussed in greater detail below, formation of one or more trenches in the surface 97 of the substrate 92 increase a surface area (in the guard region 94) to enable the reduction in the width 108 of the guard region 94 (and/or reduction in number of guard rings 101 (in particular, floating rings 106). The one or more trenches enables the guard region 94 to achieve a similar or better breakdown voltage (with the significantly reduced guard region width) while enabling recovery of the detection efficiency loss in the edge channels of the radiation sensor 90.

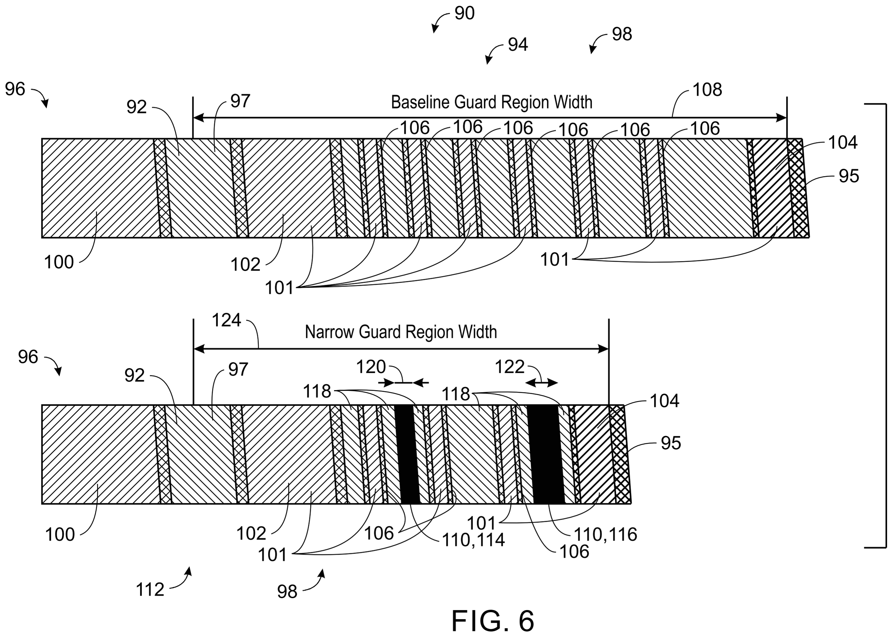

FIG. 6 is a schematic diagram comparing the guard region without trenches (top portion) of the sensor 90 to the guard region 94 with trenches 110 (bottom portion) of sensor 112. As depicted, the sensor 112 includes trenches 110 disposed adjacent to and between pairs of guard rings 101. The number of trenches 110 may vary (e.g., 1, 2, 3, or more trenches). As depicted, there are two trenches 110 (trenches 114, 116). Trench 114 is formed between a pair of floating rings 106. Trench 116 is formed between the implant ring 104 and a floating ring 106. The trenches 110 are formed in undoped regions 118. The trenches 110 may be formed anywhere in between the current capture guard electrode 102 and the floating implant ring 104 adjacent and/or between the guard rings 101 in the undoped regions 118. As depicted, a width 120 of the trench 114 is different (i.e., smaller) than a width 122 of the trench 116. In certain embodiments, the widths of the trenches 110 may be the same. In certain embodiments, the profile or shape of the trenches 110 may vary (e.g., v-shape, curved shape, rectilinear, etc.) between each other. In certain embodiments, the profile or shape of the trenches 110 may be the same. As depicted, the trenches 110 that extend along the surface 97 in a straight direction. In certain embodiments, the trenches 110 may extend along the surface 97 in a non-straight manner (e.g., in a wave-like pattern, in a zig-zag pattern, etc.). In certain embodiments, a depth of the trenches 110 may be the same. In certain embodiments, a depth of the trenches 110 may vary between each other. The trenches 110 are shallow having a depth of up to 50 micrometers. In certain embodiments, the surfaces (e.g., bottom and sides) of the trenches 110 has one or more layers disposed on them (while still maintaining a trench in the surface 97). In certain embodiments, a tin oxide layer is disposed over each surface of the trench 110. In certain embodiments, a passivation layer is disposed over each surface of the trench 110. In certain embodiments, both a tin oxide layer and a passivation layer is disposed over each surface of the trench 110.

The presence of the trenches 110 provides additional surface area in the surface area while reducing a width 124 of the guard region 94 of the sensor 112 to the width 108 (e.g., baseline guard region width) of the guard region 94 of the sensor 90. In certain embodiments, the width 124 may be reduced by up to 30 percent (or more) compared to the width 108. In certain embodiments, the width 124 may be reduced by as much as 70 micrometers (or more) compared to the width 108. The guard region 94 of the sensor 112 also has fewer guard rings 101 (in particular, floating rings 106) compared to the guard region of the sensor 90. The trenches 110 enable the guard region 94 of the sensor 112 to achieve a similar or better breakdown voltage (with the significantly reduced guard region width) while enabling recovery of the detection efficiency loss in the edge channels of the radiation sensor 112.

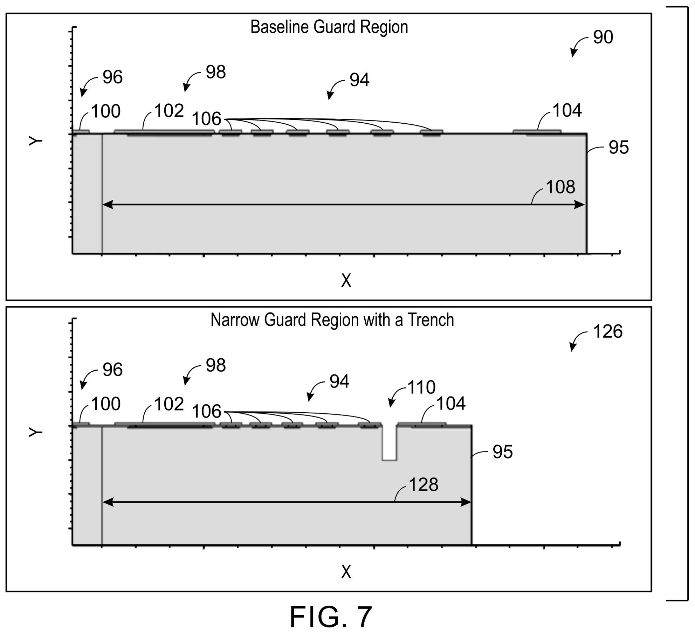

FIG. 7 depicts simulated guard region designs for use in simulated breakdown voltage comparison. The top portion of FIG. 7 depicts a side view of a guard region design for a portion of the sensor 90 in FIGS. 5 and 6 (which lacks any trenches). The bottom portion of FIG. 7 depicts a side view of a guard region design for a portion of a sensor 126 having a single trench 110 disposed between a floating ring 106 (closest to the implant ring 104) and the implant ring 104. A width 128 of the guard region 94 of the sensor 126 is smaller (e.g., by approximately 70 micrometers) than the width 108 of the guard region 94 of the sensor 90 due to the trench 110. The guard region 94 of the sensor 126 has fewer floating rings 106 than the guard region of the sensor 90 (e.g., five versus six floating rings 106, respectively).

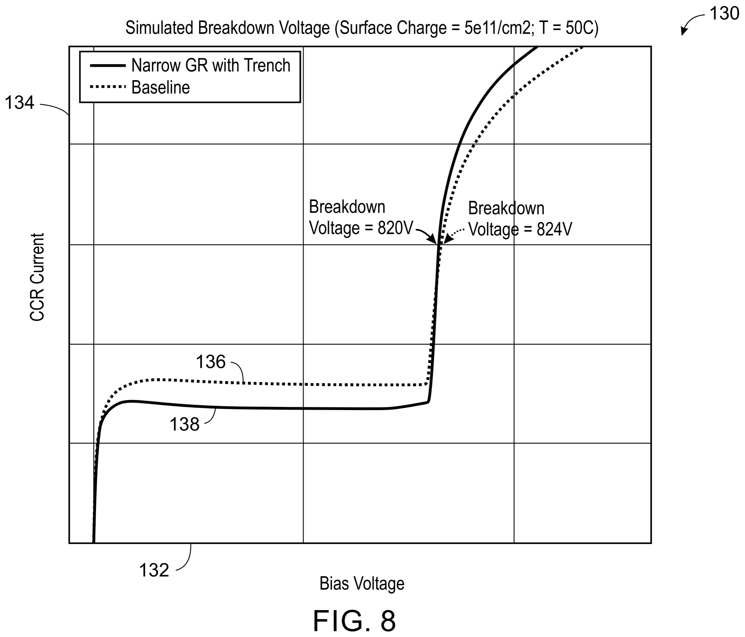

FIG. 8 depicts a graph 130 of the comparison in simulated breakdown voltage for the simulated guard region designs in FIG. 7. The graph 130 includes an x-axis 132 representing bias voltage and a y-axis 134 representing CCR current. Plot 136 represents sensor 90 lacking trenches in the guard region. Plot 138 represents sensor 126 having a single trench formed in the guard region. As depicted in the graph 130, the sensors 90, 126 have a similar breakdown voltage performance (a breakdown voltage of 824 volts (V) compared to a breakdown voltage of 820 V, respectively).

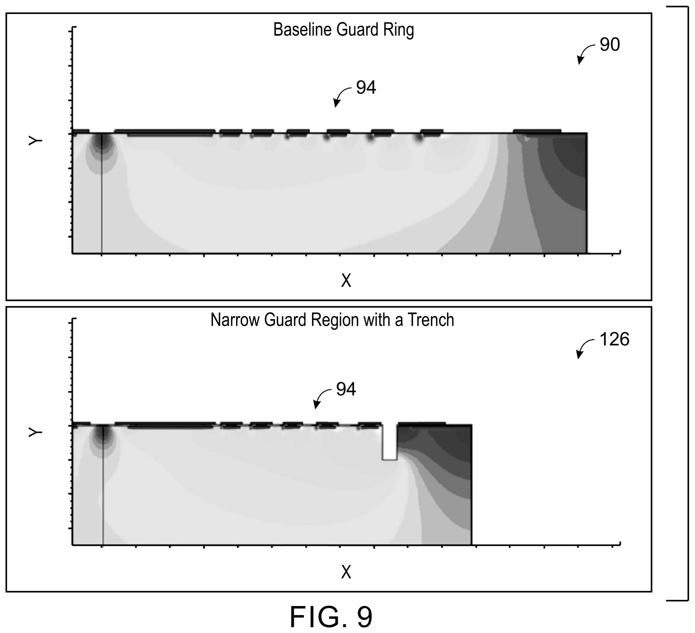

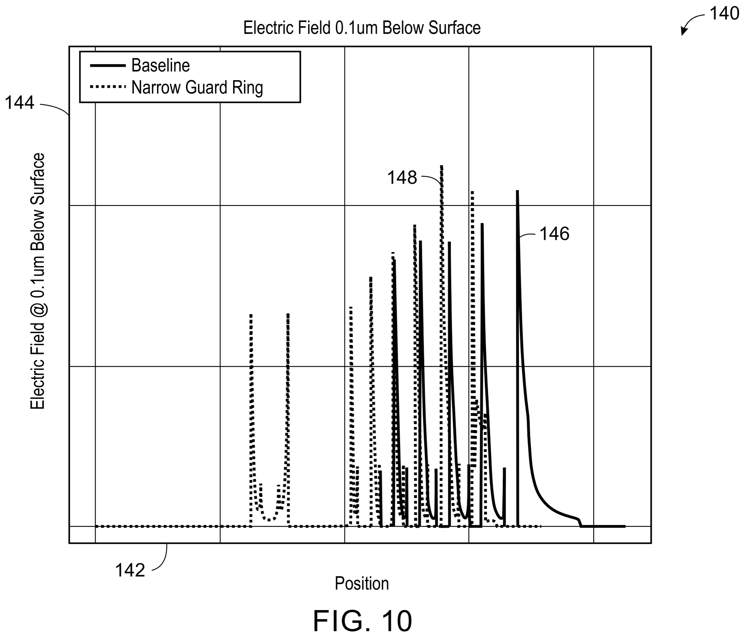

FIG. 9 depicts an electric field in the simulated guard region designs in FIG. 7 at 250 V. FIG. 10 depicts a graph 140 of a comparison of electric field between the simulated guard region designs in FIG. 7 at 0.1 micrometers below the surface. The graph 140 includes an x-axis 142 representing position (in x direction) and a y-axis 144 representing electric field at 0.1 micrometers below the surface. Plot 146 represents sensor 90 lacking trenches in the guard region. Plot 148 represents sensor 126 having a single trench formed in the guard region. As depicted in the graph 140, the sensor 126 has a similar but slightly higher electric field profiled (especially for the next to last floating ring).

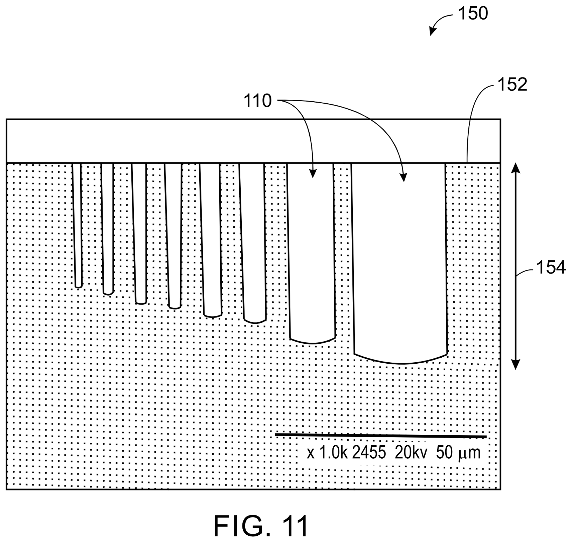

FIG. 11 depicts a depiction 150 (e.g., side view) of trenches 110 of different depths formed in a semiconductor layer 152. The trenches 110 were formed in the semiconductor layer 152 via utilizing deep reactive ion etching. A depth 154 of the trenches 110 increases from left to right with the greatest depth being approximately 50 micrometers in the far right trench 110. As noted above, the depth of the trenches 110 formed in the guard region may vary between each other. In certain embodiments, the depth of the trenches 110 may be the same.

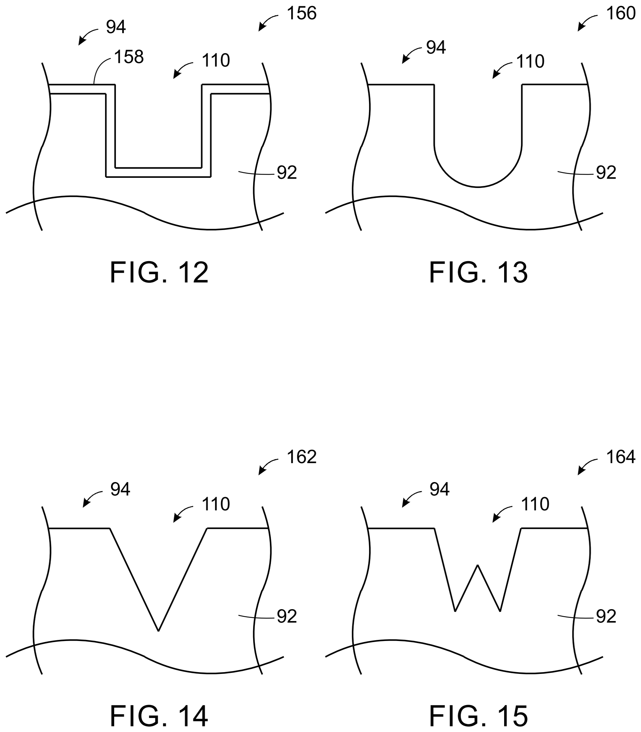

FIG. 12 depicts a schematic diagram of a side view of a portion of the guard region 94 of a sensor 156 having the trench 110 (formed in the substrate 92) with an additional layer 158 disposed (after formation of the trench 110) on the trench's surfaces (e.g., bottom and side surfaces). In certain embodiments, the additional layer 158 is a tin oxide layer. In certain embodiments, the additional layer 158 is a passivation layer. In certain embodiments, the both a tin oxide layer and a passivation layer may be disposed on the surfaces of the trench 110.

As noted above, the shape of the formed trenches may vary. The shape of the formed trench may be any shape that increases the surface area of the substrate in the inactive or dead region. FIG. 13 depicts a schematic diagram of a side view of a portion of the guard region 94 of a sensor 160 having the trench 110 (formed in the substrate 92) having a concave shape. FIG. 14 depicts a schematic diagram of a side view of a portion of the guard region 94 of a sensor 162 having the trench 110 (formed in the substrate 92) having a concave shape. FIG. 15 depicts a schematic diagram of a side view of a portion of the guard region 94 of a sensor 164 having the trench 110 (formed in the substrate 92) having a concave shape.

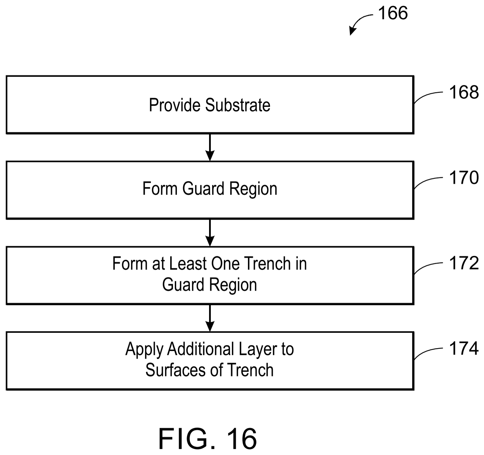

FIG. 16 is a flow chart of a method 166 of manufacturing a radiation imaging apparatus. The method 166 includes providing a substrate (e.g., semiconductor layer) with a radiation-sensitive imaging region therein (block 168). The radiation-sensitive imaging region includes a plurality of pixels disposed on a surface of the substrate. Each pixel of the plurality of pixels is configured to act as a detector element. The method 166 also includes forming a guard region including a plurality of guard rings on the surface about a periphery of the radiation-sensitive imaging region at or immediately adjacent a cut edge of the substrate and to prevent premature electrical breakdown of the radiation imaging apparatus when the radiation imaging apparatus is in use (block 170). The guard region forms an inactive region about the periphery of the radiation-sensitive imaging region. The method 166 further includes forming at least one trench in the surface (in an undoped region) in the guard region disposed about the periphery of the radiation-sensitive imaging region to improve detection efficiency of pixels of the plurality of pixels located closest to the cut edge when the radiation imaging apparatus is in use while reducing a width of the guard region (block 172). In certain embodiments, the method 166 includes applying one or more additional layers to the surfaces of the at least one trench (block 174). In certain embodiments, the additional layer is a tin oxide layer. In certain embodiments, the additional layer is a passivation layer.

Technical effects of the disclosed embodiments include providing a narrower guard region (e.g., narrower guard ring structure). In particular, one or more trenches are formed in a substrate (e.g., semiconductor layer) of a radiation sensor in guard region (e.g., between guard rings) to increase a surface area to enable the reduction in the width of the guard region (and/or reduction in number of guard rings). The one or more trenches enables the guard region to achieve a similar or better breakdown voltage (with the significantly reduced guard region width) while enabling recovery of the detection efficiency loss in the edge channels of the radiation sensor. As noted, the narrower guard region improves detection efficiency of pixels in the edge of the radiation sensor. Technical effects of the disclosed embodiments include directly improving the image quality while reducing the complexity of system calibration and correction algorithms. Technical effects of the disclosed embodiments include enabling a simpler detector design (e.g., straight sensors as opposed to overlapping sensors) to reduce cost. Technical effects of the disclosed embodiments include reducing the inactive (dead) area on the periphery of the sensor by 30 percent or more.

The disclosure also provides support for a radiation imaging apparatus, comprising: a substrate; a radiation-sensitive imaging region in the substrate comprising a plurality of pixels disposed on a surface of the substrate, wherein each pixel of the plurality of pixels is configured to act as a detector element; a guard region disposed on the surface and comprising a plurality of guard rings disposed about a periphery of the radiation-sensitive imaging region at or immediately adjacent a cut edge of the substrate, wherein the guard region is configured to prevent premature electrical breakdown of the radiation imaging apparatus, wherein the guard region forms an inactive region about the periphery of the radiation-sensitive imaging region, and the guard region comprises at least one trench formed in the surface in the guard region disposed about the periphery of the radiation-sensitive imaging region, and wherein the at least one trench is configured to improve detection efficiency of pixels of the plurality of pixels located closest to the cut edge while reducing a width of the guard region. In a first example of the radiation imaging apparatus, the at least one trench is disposed adjacent to a guard ring of the plurality of guard rings. In a second example of the radiation imaging apparatus, optionally including the first example, the at least one trench is disposed between a pair of guard rings of the plurality of guard rings. In a third example of the radiation imaging apparatus, optionally including one or both of the first and second examples, the radiation imaging apparatus further comprises a plurality of trenches formed in the surface in the guard region about the periphery of the radiation-sensitive imaging region, wherein each trench of the plurality of trenches is disposed between a respective pair of guard rings of the plurality of guard rings. In a fourth example of the radiation imaging apparatus, optionally including one or more or each of the first through third examples, the plurality of trenches vary in width. In a fifth example, optionally including one or more or each of the first through fourth examples, the plurality of trenches vary in depth. In a sixth example, optionally including one or more or each of the first through fifth examples, the at least one trench is formed in an undoped region. In a seventh example, optionally including one or more or each of the first through sixth examples, the radiation imaging apparatus further comprises a passivation layer disposed over each surface of the at least one trench. In an eighth example, optionally including one or more or each of the first through seventh examples, the radiation imaging apparatus further comprises a tin oxide layer disposed over each surface the at least one trench. In a ninth example, optionally including one or more or each of the first through eighth examples, the radiation imaging apparatus comprises a photon counting X-ray detector. In a tenth example, optionally including one or more or each of the first through ninth examples, the photon counting X-ray detector is configured to be utilized with a computed tomography imaging system or a projectional radiographic imaging system.

The disclosure also provides support for a method of manufacturing a radiation imaging apparatus, comprising: providing a substrate with a radiation-sensitive imaging region therein, wherein the radiation-sensitive imaging region comprises a plurality of pixels disposed on a surface of the substrate, wherein each pixel of the plurality of pixels is configured to act as a detector element; forming a guard region comprising a plurality of guard rings on the surface about a periphery of the radiation-sensitive imaging region at or immediately adjacent a cut edge of the substrate and to prevent premature electrical breakdown of the radiation imaging apparatus when the radiation imaging apparatus is in use, wherein the guard region forms an inactive region about the periphery of the radiation-sensitive imaging region; and forming at least one trench in the surface in the guard region disposed about the periphery of the radiation-sensitive imaging region to improve detection efficiency of pixels of the plurality of pixels located closest to the cut edge when the radiation imaging apparatus is in use while reducing a width of the guard region. In a first example of the method, the method further comprises utilizing deep reactive ion etching to form the at least trench in the surface. In a second example of the method, optionally including the first example, the at least one trench is disposed adjacent to a guard ring of the plurality of guard rings. In a third example of the method, optionally including one or both of the first and second examples, the at least one trench is disposed between a pair of guard rings of the plurality of guard rings. In a fourth example of the method, optionally including one or more or each of the first through third examples, the method further comprises forming a plurality of trenches in the surface in the guard region about the periphery of the radiation-sensitive imaging region, wherein each trench of the plurality of trenches is disposed between a respective pair of guard rings of the plurality of guard rings. In a fifth example of the method, optionally including one or more or each of the first through fourth examples, the plurality of trenches vary in width. In a sixth example of the method, optionally including one or more or each of the first through fifth examples, the plurality of trenches vary in depth. In a seventh example of the method, optionally including one or more or each of the first through sixth examples, the at least one trench is formed in an undoped region.

The disclosure also provides support for a photon-counting X-ray detector, comprising: a plurality of detector sub-modules, wherein each detector sub-module comprises: a semiconductor layer; a radiation-sensitive imaging region in the semiconductor layer, wherein the radiation-sensitive imaging region comprises a plurality of pixels disposed on a surface of the semiconductor layer, wherein each pixel of the plurality of pixels is configured to act as a detector element; and a guard region disposed on the surface and comprising a plurality of guard rings disposed about a periphery of the radiation-sensitive imaging region at or immediately adjacent a cut edge of the semiconductor layer, wherein the guard region is configured to prevent premature electrical breakdown of the detector sub-module, wherein the guard region forms an inactive region about the periphery of the radiation-sensitive imaging region, and the guard region comprises at least one trench formed in the surface in the guard region disposed about the periphery of the radiation-sensitive imaging region, and wherein the at least one trench is configured to improve detection efficiency of pixels of the plurality of pixels located closest to the cut edge while reducing a width of the guard region.

The techniques presented and claimed herein are referenced and applied to material objects and concrete examples of a practical nature that demonstrably improve the present technical field and, as such, are not abstract, intangible or purely theoretical. Further, if any claims appended to the end of this specification contain one or more elements designated as "means for [perform]ing [a function]..." or "step for [perform]ing [a function]...", it is intended that such elements are to be interpreted under 35 U.S.C. 112(f). However, for any claims containing elements designated in any other manner, it is intended that such elements are not to be interpreted under 35 U.S.C. 112(f).

This written description uses examples to disclose the present subject matter, including the best mode, and also to enable any person skilled in the art to practice the subject matter, including making and using any devices or systems and performing any incorporated methods. The patentable scope of the subject matter is defined by the claims, and may include other examples that occur to those skilled in the art. Such other examples are intended to be within the scope of the claims if they have structural elements that do not differ from the literal language of the claims, or if they include equivalent structural elements with insubstantial differences from the literal languages of the claims.

## Claims

1. A radiation imaging apparatus, comprising:
a substrate (92);
a radiation-sensitive imaging region (96) in the substrate (92) including a plurality of pixels (93) disposed on a surface of the substrate (92), wherein each pixel (93) of the plurality of pixels (93) is configured to act as a detector element;
a guard region (94) disposed on the surface and including a plurality of guard rings (101) disposed about a periphery of the radiation-sensitive imaging region (96) at or immediately adjacent a cut edge (95) of the substrate (2), wherein the guard region (94) is configured to prevent premature electrical breakdown of the radiation imaging apparatus, wherein the guard region (94) forms an inactive region (98) about the periphery of the radiation-sensitive imaging region (96), and the guard region (94) includes at least one trench (110) formed in the surface in the guard region (94) disposed about the periphery of the radiation-sensitive imaging region (96), and wherein the at least one trench (110) is configured to improve detection efficiency of pixels (93) of the plurality of pixels (93) located closest to the cut edge (95) while reducing a width (108) of the guard region (94).

2. The radiation imaging apparatus of claim 1, wherein the at least one trench (110) is disposed adjacent to a guard ring (101) of the plurality of guard rings (101).

3. The radiation imaging apparatus of claim 2, wherein the at least one trench (110) is disposed between a pair of guard rings (101) of the plurality of guard rings (101).

4. The radiation imaging apparatus of claim 1, further including a plurality of trenches (110) formed in the surface in the guard region (94) about the periphery of the radiation-sensitive imaging region (96), wherein each trench (110) of the plurality of trenches (110) is disposed between a respective pair of guard rings (101) of the plurality of guard rings (101).

5. The radiation imaging apparatus of claim 4, wherein the plurality of trenches (110) vary in width.

6. The radiation imaging apparatus of claim 4, wherein the plurality of trenches (110) vary in depth.

7. The radiation imaging apparatus of claim 1, wherein the at least one trench (110) is formed in an undoped region (118).

8. The radiation imaging apparatus of claim 1, further including a passivation layer disposed over each surface of the at least one trench (110).

9. The radiation imaging apparatus of claim 1, further including a tin oxide layer disposed over each surface the at least one trench (110).

10. The radiation imaging apparatus of claim 1, wherein the radiation imaging apparatus comprises a photon counting X-ray detector.

11. The radiation imaging apparatus of claim 10, wherein the photon counting X-ray detector is configured to be utilized with a computed tomography imaging system or a projectional radiographic imaging system.

12. A method of manufacturing a radiation imaging apparatus, comprising:
providing a substrate (92) with a radiation-sensitive imaging region (96) therein, wherein the radiation-sensitive imaging region (96) comprises a plurality of pixels (93) disposed on a surface of the substrate (92), wherein each pixel (93) of the plurality of pixels (93) is configured to act as a detector element;
forming a guard region (94) including a plurality of guard rings (101) on the surface about a periphery of the radiation-sensitive imaging region (96) at or immediately adjacent a cut edge (95) of the substrate (92) and to prevent premature electrical breakdown of the radiation imaging apparatus (96) when the radiation imaging apparatus is in use, wherein the guard region (94) forms an inactive region (98) about the periphery of the radiation-sensitive imaging region (96); and
forming at least one trench (110) in the surface in the guard region (94) disposed about the periphery of the radiation-sensitive imaging region (96) to improve detection efficiency of pixels (93) of the plurality of pixels (93) located closest to the cut edge (95) when the radiation imaging apparatus (96) is in use while reducing a width (108) of the guard region (96).

13. The method of claim 12, further including utilizing deep reactive ion etching to form the at least trench (110) in the surface.

14. The method of claim 12, wherein the at least one trench (110) is disposed adjacent to a guard ring (101) of the plurality of guard rings (101).

15. The method of claim 14, wherein the at least one trench (110) is disposed between a pair of guard rings (101) of the plurality of guard rings (101).
